# EUROPEAN PATENT SPECIFICATION

(11) **EP 1 851 355 B1**
(45) Date of publication and mention of the grant of the patent: **13.04.2011**
(21) Application number: 06735680.8
(22) Date of filing: 22.02.2006
(51) Int. Cl.: C23C 14/24, C30B 23/00

(54) **EFFUSION CELL VALVE**
EFFUSIONSZELLVENTIL
SOUPAPE DE CELLULE D'EFFUSION

(30) Priority: 22.02.2005 US 655124 P
(43) Date of publication of application: 07.11.2007
(73) Proprietor: E-Science, Inc., Hudson, Wisconsin 54016 (US)
(72) Inventor: BICHRT, Craig, Hudson, Wisconsin 54016 (US)
(74) Representative: Thacker, Darran Ainsley
(86) International application number: PCT/US2006/006118
(87) International publication number: WO 2006/091598

(56) References cited:
- US-A- 5 714 008
- US-A- 6 162 300
- US-A1- 2004 129 216

## Description

### FIELD OF THE INVENTION

The invention relates to vacuum evaporation, and more particularly relates to valves used in effusion-type evaporative cells.

### BACKGROUND INFORMATION

Vacuum deposition techniques are used to deposit different types of materials onto substrates to form thin films. Vapor sources that modulate the flux with an integral metal needle valve or a moveable metal shutter are known in the art of molecular beam epitaxy (MEB). The majority of solid or molten source materials and the resulting metal vapors are reactive with metals at elevated temperatures. Thus, the current MBE sources with metal valves or metal shutters may only be used with a few relatively non-reactive source materials. If there is a reaction between the source material and the containing vessel or valve components the thin films become contaminated.

Valved sources using pyrolytic boron nitride (PBN) have been developed to be used with some of the more corrosive materials. There are limitations on the geometry that is attainable with PBN because of the restrictive fabrication process that is required to produce the components. The use of graphite and silicon nitride as a material for the various components that make up a valved cell including the crucible and valve allow for much greater flexibility in the geometry, function, performance and cost of these cells.

U.S. Patent No. 6,162,300 discloses an effusion cell having a ceramic needle valve mechanism.
U.S. Patent Application No. 2004/0129216 discloses molecular beam epitaxy equipment including an effusion cell for evaporation of source material. The effusion cell is closed by a valve seat (diaphragm) having at least one opening and a valve disk (mobile plate) positioned outside the valve seat such that the distance between the valve disk from an exterior surface of the valve seat is variable.
U.S. Patent No. 5,714,008 discloses an effusion cell having means for adjusting the angular distribution of the metal vapors that are produced by heating source material.

### SUMMARY OF THE INVENTION

This object is achieved with the present invention by the subject matter as indicated in claim 1.

The present invention is a thermal evaporation source that includes a ceramic crucible and valve assembly. The reservoir and valve assembly are heated radiatively using resistively heated filaments. The heat shielding metal foils and supporting ceramic pieces are configured to provide for separate thermal zones. The temperature of each thermal zone is typically monitored using a thermocouple or pyrometer that is specific to each thermal zone. A temperature controlling device may be used to both monitor the temperature of the zone and adjust the power supplied to the filament in order to apply any desired thermal gradients to the invention. After the requisite thermal profile is applied to the invention, the flow of vapors evaporating from the source may be modulated by further adjusting the position of a ceramic needle that seats in the ceramic plug at the top of the source. The position of the valve is typically controlled precisely using a micrometer or other micro-positioning device such as a stepper motor or servo motor and position encoder.

An aspect of the present invention is to provide an effusion cell comprising a crucible having an interior chamber and an open end; a valve seat adjacent the open end of the crucible comprising an aperture in flow communication with the open end of the crucible, and a seating surface surrounding the aperture; an outlet nozzle downstream from the valve seat; and a valve disk comprising a seating surface, wherein the valve disk is axially movable inside the outlet nozzle along a length of the effusion cell from a closed position in which the seating surfaces of the valve seat and valve disk contact each other, to an open position in which the seating surfaces of the valve seat and valve disk are disengaged.

These and other aspects of the present invention will be more apparent from the following description.

### BRIEF DESCRIPTION OF THE DRAWING

Fig. 1 is an isometric view of a portion of an effusion cell including a disk valve in accordance with an embodiment of the present invention.

Fig. 2 is an end view of the effusion cell of Fig. 1.

Fig. 3 is a longitudinal sectional view of the effusion cell taken through section A-A of Fig. 2, with the addition of a cylindrical enclosure and a crucible, showing the disk valve in an open position.

Fig. 4 is a longitudinal sectional view of the effusion cell taken through section A-A of Fig. 2, with the addition of a cylindrical enclosure and a crucible, showing the disk valve in the closed position.

Fig. 5 is a longitudinal sectional view of an effusion cell valve including a valve seat, valve disk, and outlet nozzle in accordance with an embodiment of the present invention.

Fig. 6 is a longitudinal sectional view of an effusion cell valve including a valve seat, valve disk, and outlet nozzle in accordance with another embodiment of the present invention.

Fig. 7 is a longitudinal sectional view of an effusion cell valve including a valve seat, valve disk, and outlet nozzle in accordance with a further embodiment of the present invention.

Fig. 8 is a graph of beam equivalent pressure (BEP) vs. time for two test runs, demonstrating repeatability of valve position for an effusion cell in accordance with an embodiment of the present invention.

Fig. 9 is a graph of BEP vs. time for two test runs, demonstrating repeatability of valve position for an effusion cell in accordance with an embodiment of the present invention.

### DETAILED DESCRIPTION

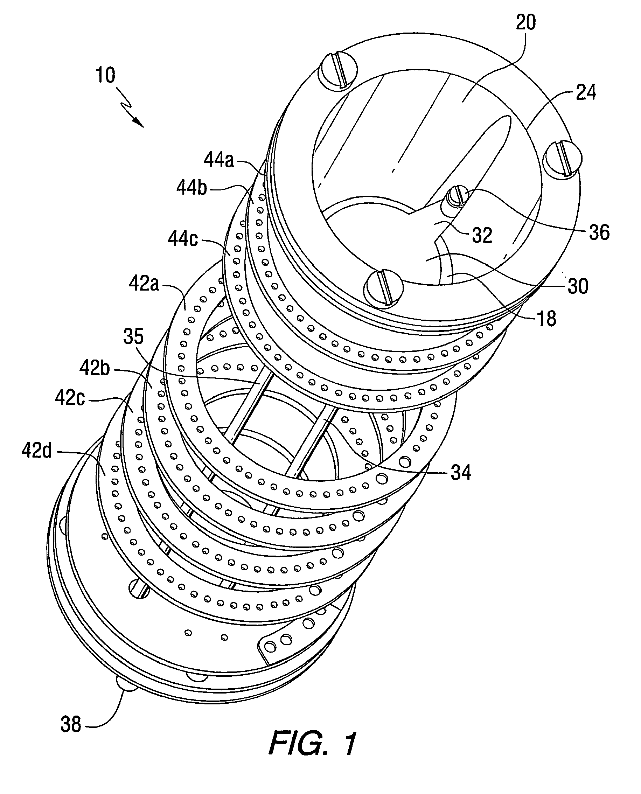

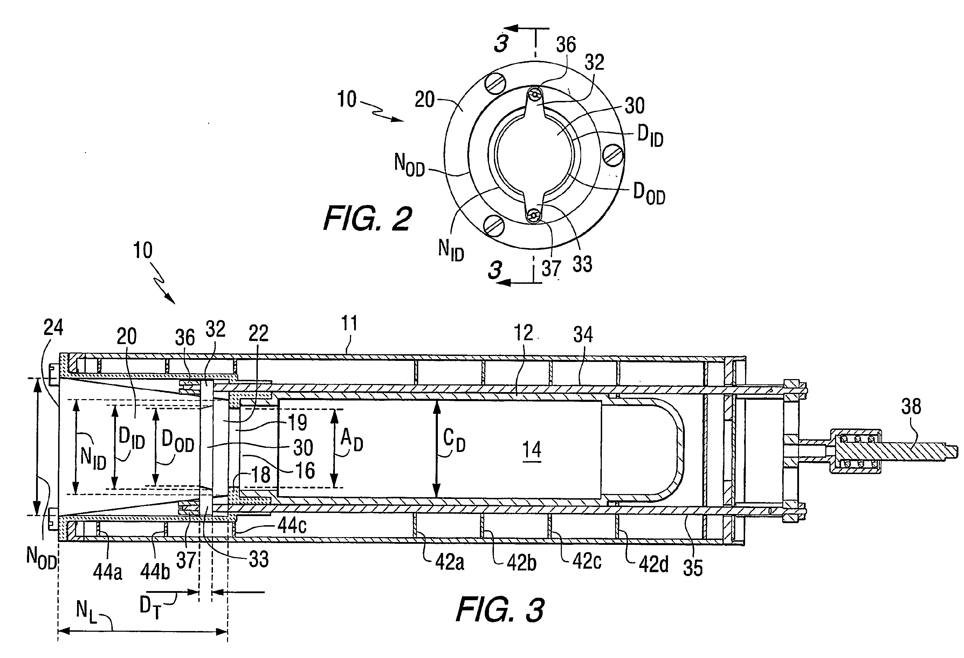

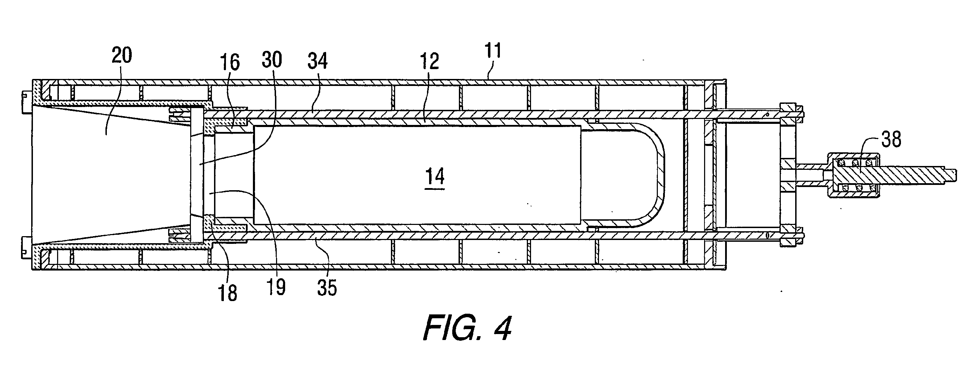

Figs. 1-4 illustrate an effusion cell 10 in accordance with an embodiment of the present invention. In Figs. 1 and 2, the effusion cell 10 is shown without its outer enclosure, while in Figs. 3 and 4 the cylindrical enclosure 11 is shown. The enclosure may be made of any suitable material such as tantalum, e.g., inner and outer tantalum sleeves separated by an insulating layer of knurled tantalum foil. The effusion cell 10 includes a crucible 12, shown in Figs. 3 and 4, made of a material such as graphite, silicon carbide or the like. The crucible 12 has a crucible chamber 14 with an open end 16. A valve seat 18 having an opening or aperture 19 is mounted at the open end 16 of the crucible 12 by means such as a press fitting, a threaded connection or fasteners. The crucible 12 has an inner diameter C_{D}, while the valve seat aperture 19 has a diameter A_{D}. In one embodiment, the ratio of A_{D}:C_{D} may be relatively large, e.g., greater than 0.2:1, typically greater than 0.5:1. However, a smaller A_{D}:C_{D} ratio may be used for some applications, e.g., as low as 0.1:1 or 0.01:1.

An outlet nozzle 20 is provided adjacent to the open end 16 of the crucible 12. In the embodiment shown in the figures, the valve seat 18 and the outlet nozzle 20 are provided as an integral unit. However, the valve seat 18 and outlet nozzle 20 may alternatively be provided as separate pieces. The outlet nozzle 20 includes an inlet end 22 adjacent to the crucible 12, and an outlet end 24 at the distal end of the effusion cell 10 downstream from the inlet end 22.

A valve disk 30 is mounted in the nozzle 20 adjacent the inlet end 22, and is axially movable with respect to the valve seat 18. The valve disk 30 includes radially extended ears 32 and 33. Actuator rods 34 and 35 running along the outside of the crucible 12 are connected to the valve disk ears 32 and 33, respectively. The actuator rods 34 and 35 are attached to the ears 32 and 33 by fasteners 36 and 37 such as nuts threaded on to the ends of the actuator rods 34 and 35. A spring-loaded coupling 38 is connected between the actuator rods 34 and 35 and a valve controller (not shown) which controls that axial movement of the actuator rods 34 and 35 in order to selectively open and close the valve disk 30 against the valve seat 18. The spring-loaded coupling 38 protects the valve seat 18 and valve disk 30 from being damaged when they contact each other. An example of a valve controller that may be used with the present effusion cell valve is disclosed in U.S. Patent No. 6,162,300. The valve controller allows the valve position to be precisely controlled from outside the vacuum.

The valve seat 18, outlet nozzle 20 and valve disk 30 may be made of any suitable materials such as machined graphite coated with a carbon-containing coating, for example, a pyrolytic graphite coating, silicon carbide coating, or the like. Other suitable materials for the valve seat 18, outlet nozzle 20 and valve disk 30 include ceramics such as pyrolytic boron nitride, silicon carbide and/or metal oxides such as alumina, magnesia, etc.

The valve disk 30 may have a cylindrical shape, or may have a tapered or conical shape, for example, as shown in Figs. 3-5. The tapered valve disk 30 shown in Figs. 3-5 has an inlet diameter D_{ID}, and an outlet diameter D_{OD}. The disk 30 has a thickness D_{T}. The ratio of D_{ID} or D_{OD} to D_{T} may be relatively large, e.g., greater than 2:1, typically greater than 3:1 or 5:1. In one embodiment, the ratio is greater than 10:1. In the embodiment shown in Figs. 3-5, the disk 30 is tapered inwardly toward the outlet end 24 of the nozzle 20 at an angle of about 10°. However, any other suitable taper angle may be used, e.g., from +45° to - 45°.

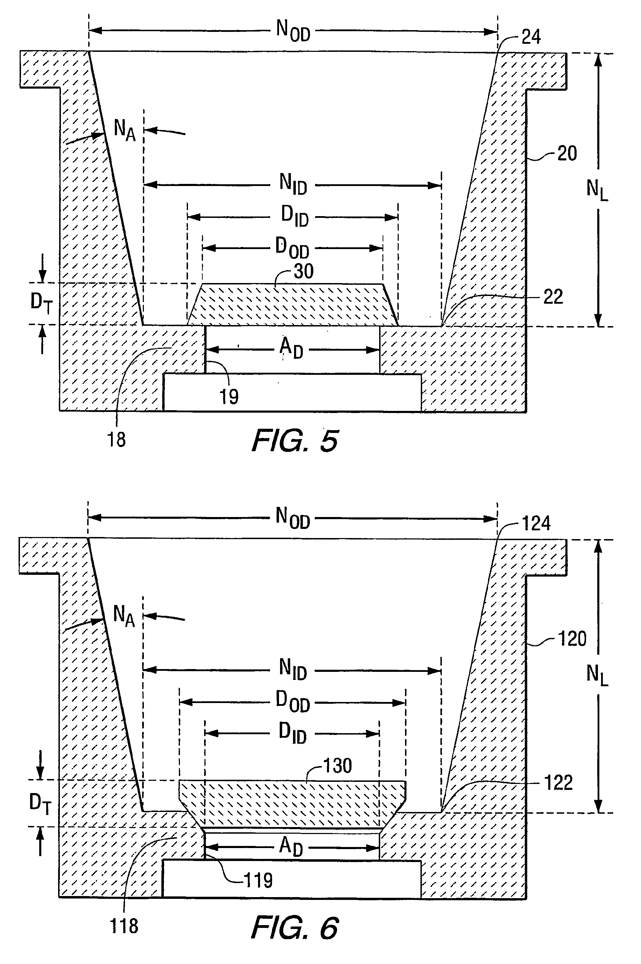

The inlet end 22 of the nozzle 20 has an inlet diameter N_{ID} which corresponds to the inside diameter of the nozzle at the inlet end 22. The outlet end 24 of the nozzle 20 has an outlet diameter N_{OD} representing the inside diameter at the outlet end 24. The ratio of N_{OD}:N_{ID} is typically less than 3:1, e.g., from about 1:1 to 2.5:1. In one embodiment, the ratio of N_{OD}:N_{ID} is from about 1.4:1 to about 2:1. As shown in Fig. 5, the nozzle 20 has an outward taper angle N_{A}, e.g., from about 1 to about 45 degrees, for example, from about 5 to about 20 degrees.

The nozzle 20 has a length N_{L} measured from the inlet end 22 to the outlet end 24 of the nozzle 20. The ratio of N_{L}:N_{OD} is typically greater than 0.2:1, e.g., from about 0.5:1 to about 10:1. For example, the ratio of N_{L}:N_{OD} may be from about 0.6:1 to about 3:1, or from about 0.7:1 to about 2:1.

The ratio of the valve disk inlet diameter D_{ID} to the nozzle inlet diameter N_{ID} (D_{ID}:N_{ID}) is typically greater than 0.3:1, e.g., greater than 0.5:1. The ratio of the valve disk inlet diameter D_{ID} to the crucible inner diameter C_{D} (D_{ID}:C_{D}) is typically greater than 0.1:1, e.g., greater than 0.2:1 or 0.5:1.

Fig. 6 illustrates an effusion cell valve similar to that shown in Fig. 5, with a modified valve seat and valve disk. In the embodiment shown in Fig. 6, the outlet nozzle 120 has an inlet end 122 and an outlet end 124. The valve seat 118 has a cylindrical aperture 119 and a tapered conical seating surface. The valve disk 130 has a flat, generally cylindrical shape with a tapered portion forming a conical seating surface which contacts the conical seating surface of the valve seat 118 when the valve is closed. The valve disk 130 has an inlet diameter D_{ID} measured at the edge between the bottom surface and the conical seating surface of the disk. The valve disk 130 has an outlet diameter D_{OD} and a thickness D_{T}.

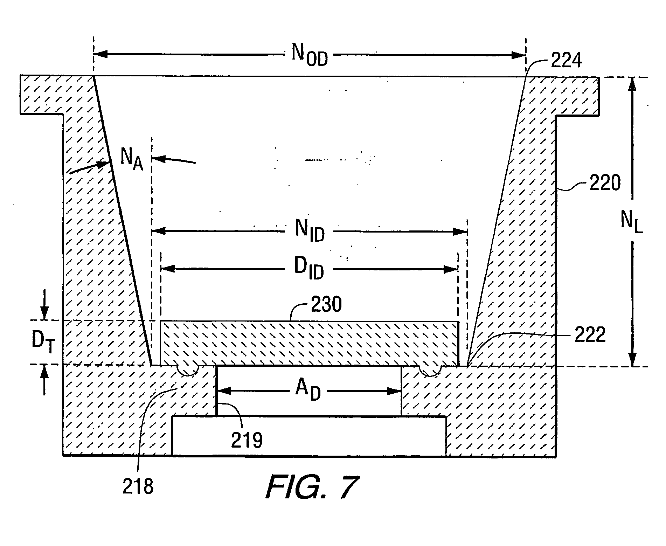

Fig. 7 illustrates an effusion cell valve similar to that shown in Fig. 5, with a modified valve seat and valve disk. In the embodiment shown in Fig. 7, the outlet nozzle 220 has an inlet end 222 and an outlet end 224. The valve seat 218 has a cylindrical aperture 219. The valve disk 230 has a flat, generally cylindrical shape with a raised ring extending from its bottom surface that is received in an annular recess in the valve seat 218 when the valve is closed. The valve disk 230 has an inlet diameter D_{ID} which is also equal to its outlet diameter. The valve disk 230 has a thickness D_{T}.

As shown most clearly in Figs. 1-4, crucible heating element supports 42a-d surround the crucible 12 and are used to support conventional heating wires (not shown) which are threaded through holes in the supports 42a-d and run axially along the length of the cell. Nozzle heating element supports 44a-c surround the nozzle 20 and are used to support conventional heating wires (not shown) which are threaded through holes in the supports 44a-c and run axially along the length of the cell. The heating element supports 42a-d and 44a-c and their respective heating wires provide for independently heated thermal zones. Standard thermocouples (not shown) may be used for control of the temperature of the two independently heated thermal zones.

The two thermal zones include a lower zone surrounded by the heating element supports 42a-d that contains the reservoir portion of the crucible, and an upper zone surrounded by the heating element supports 44a-c that contains the valve mechanism. The upper thermal zone may be maintained at a higher temperature preventing condensation of evaporant on the valve mechanism. The lower thermal zone may be maintained at a temperature which provides the desired range of flux exiting the effusion cell.

In accordance with the present invention, the flux of the vapor material exiting the nozzle 20 of the effusion cell 10 can be controlled, and the flux may be quickly adjusted in comparison with conventional MBE techniques. By selectively controlling the position of the valve disk 30, the flux is continuously variable to desired levels. This controllable flux may be accomplished in many cases without the necessity of changing the temperature of the crucible and/or nozzle. For example, the flux may be variable over two orders of magnitude, e.g., from 1.33·10⁻⁷ to 1.33·10⁻⁵ Pa (10⁻⁹ to 10⁻⁷ Torr). The ability to maintain a substantially constant temperature while adjusting the material deposition flux represents an improvement over conventional MBE techniques in which temperature adjustments were necessary, e.g., when switching to a different deposition rate.

Tests were conducted using an effusion cell valve similar to that shown in Figs. 1-4 installed on a commercially available MBE system consisting of twelve effusion cell ports, a substrate manipulator capable of rotating and heating a substrate and a beam flux monitor to measure the rate of evaporation from the effusion cells.

To characterize the cell, the beam flux monitor was used to measure the evaporation rate of material in the cell. In this case, the beam flux monitor used was an ion gauge which measures the total pressure of the volume within the gauge itself. This method of measuring beam flux is generally accepted and the value measured is referred to as the beam equivalent pressure, or BEP, and is commonly given in units ot Torr.

The tests using the beam flux monitor demonstrated the range of the valve, the reproductibility of the BEP vs. valve position, and the stability of BEP for a particular valve position over time. It was found that the BEP of the valve in the off position was nearly two orders of magnitude less than the BEP of the valve in the full on position. The BEP was shown to be reproducible within 1% of the value at each position. Stability also was within 0.5%a when the valve was held in one position for a 60 minute period.

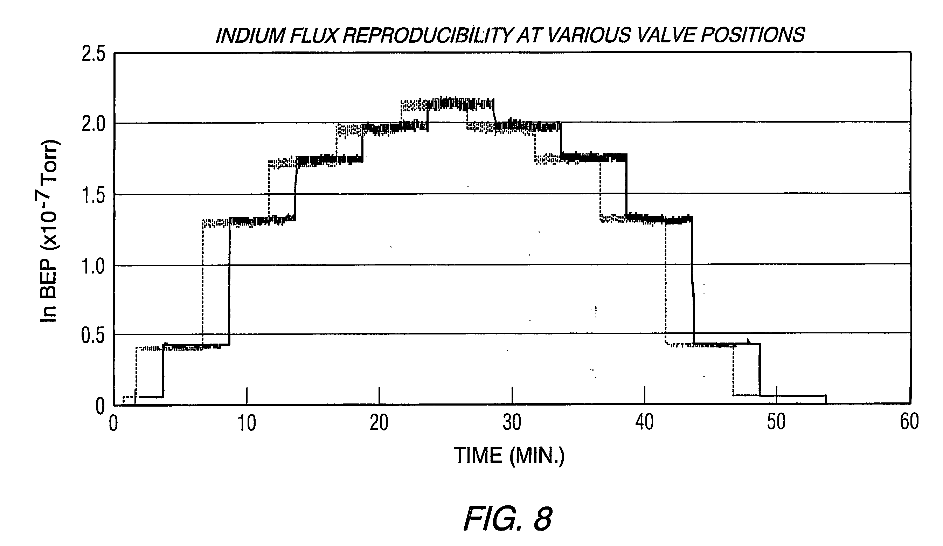

Fig. 8 shows the results when the valve is stepped from 0 to 200 over 40 position increments. Each position equates to 0.0254 mm (0.001 inch) travel. The reproducibility of each position was within 1% and near the noise level of the gauge. This matches the performance of a non-valved effusion cell using temperature changes to change the value of the flux.

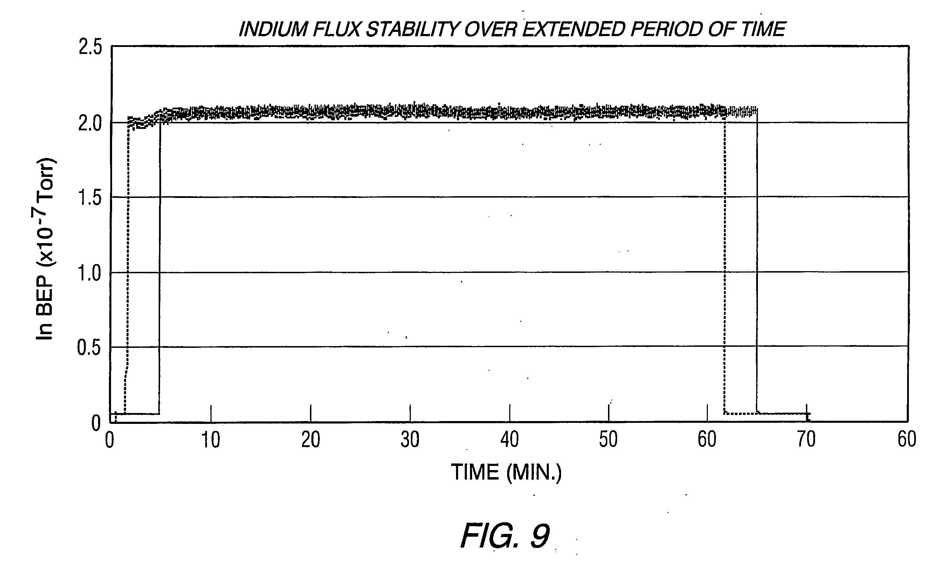

Fig. 9 shows the stability of one valve position over a 60 minute period of time. In this case, once the initial change of opening the valve stabilized, no appreciable change occurred over the duration of the test. This was better than the results seen with a non-valved effusion cell which would see a slight drop in deposition rate due to effects of material depletion.

Whereas particular embodiments of this invention have been described above for purposes of illustration, it will be evident to those skilled in the art that numerous variations of the details of the present invention may be made without departing from the invention as defined in the appended claims.

## Claims

1. An effusion cell (10) comprising:
a crucible (12) having an interior chamber (14) and an open end (16);
a valve seat (18, 118, 218) adjacent the open end (16) of the crucible (12) comprising an aperture (19, 119, 219) in flow communication with the open end (16) of the crucible (12), and a seating surface surrounding the aperture (19, 119, 219);
an outlet nozzle (20, 120, 220) downstream from the valve seat (18, 118, 218); and
a valve disk (30, 130, 230) comprising a seating surface, wherein the valve disk (30, 130, 230) is axially movable inside the outlet nozzle (20, 120, 220) along a length of the effusion cell (10) from a closed position in which the seating surfaces of the valve seat (18, 118, 218) and valve disk (30, 130, 230) contact each other, to an open position in which the seating surfaces of the valve seat (18, 118, 218) and valve disk (30, 130, 230) are disengaged;
**characterised in that** at least the portions of the seating surfaces of the valve seat (18, 118, 218) and the valve disk (30, 130, 230) that are in contact with each other when the valve disk (30, 130 230) is in the closed position are substantially planar.

2. An effusion cell (10) according to Claim 1, wherein the aperture (19, 119, 219) of the valve seat (18, 118, 218) has a diameter A_{D}, the crucible chamber (14) has an inner diameter C_{D}, and the ratio of A_{D}:C_{D} is at least 0.01:1.

3. An effusion cell (10) according to Claim 2, wherein the ratio of A_{D}:C_{D} is at least 0.2:1.

4. An effusion cell (10) according to Claim 2, wherein the ratio of A_{D}:C_{D} is from 0.5:1 to 1:1.

5. An effusion cell (10) according to Claim 1, wherein the aperture (19, 119, 219) of the valve seat (18, 118, 218) has a diameter A_{D}, the crucible chamber (14) has an inner diameter C_{D}, the valve disk (30, 130, 230) has an inlet diameter D_{ID}, and the ratio of A_{D}:C_{D} and/or the ratio of D_{ID}:C_{D} is greater than 0.1:1.

6. An effusion cell (10) according to Claim 5, wherein the ratio of A_{D}:C_{D} is greater than 0.2:1.

7. An effusion cell (10) according to Claim 5, wherein the ratio of A_{D}:C_{D} is greater than 0.5:1.

8. An effusion cell (10) according to Claim 5, wherein the ratio of D_{ID}:C_{D} is greater than 0.2:1.

9. An effusion cell (10) according to Claim 5, wherein the ratio of D_{ID}:C_{D} is greater than 0.5:1.

10. An effusion cell (10) according to any preceding Claim, wherein the substantially planar seating surface of the valve seat (18, 218) is in a plane substantially perpendicular to the axial length of the effusion cell (10).

11. An effusion cell (10) according to any preceding Claim, wherein a portion of the seating surface of the valve seat (218) is recessed or raised from the substantially planar seating surface.

12. An effusion cell (10) according to any preceding Claim, wherein the substantially planar seating surface of the valve disk (30, 230) is in a plane substantially perpendicular to the axial length of the effusion cell (10).

13. An effusion cell (10) according to any preceding Claim, wherein a portion of the seating surface of the valve disk (130) is recessed or raised from the substantially planar seating surface.

14. An effusion cell (10) according to Claim 1, wherein the valve disk (30, 130, 230) has an inlet diameter D_{ID}, a thickness D_{T}, and the ratio of D_{ID}:D_{T} is greater than 2:1.

15. An effusion cell (10) according to Claim 14, wherein the ratio of D_{ID}:D_{T} is greater than 5:1.

16. An effusion cell (10) according to Claim 14, wherein the ratio of D_{ID}:D_{T} is greater than 10:1.

17. An effusion cell (10) according to any preceding Claim, wherein the valve disk (30, 130) has a tapered side.

18. An effusion cell (10) according to Claim 17, wherein the tapered side of the valve disk (30) is inwardly tapered toward an outlet end of the effusion cell (10).

19. An effusion cell (10) according to any preceding Claim, wherein the outlet nozzle (20, 120, 220) has an inlet diameter N_{ID}, the valve disk (30, 130, 230) has an inlet diameter D_{ID}, and the ratio of D_{ID}:N_{ID} is greater than 0.3:1.

20. An effusion cell (10) according to Claim 1.9, wherein the ratio of D_{ID}:N_{ID} is greater than 0.5:1.

21. An effusion cell (10) according to any preceding Claim, wherein the outlet nozzle (20, 120, 220) and valve seat (18, 118, 218) are integral.

## Patentansprüche

1. Effusionszelle (10), aufweisend:
einen Tiegel (12) mit einer inneren Kammer (14) und einem offenen Ende (16);
einen Ventilsitz (18, 118, 218) benachbart zu dem offenen Ende (16) des Tiegels (12), aufweisend eine Öffnung (19, 119, 219) in Strömungsverbindung mit dem offenen Ende (16) des Tiegels (12) und eine Sitzfläche, welche die Öffnung (19, 119, 219) umgibt;
eine Austrittsdüse (20, 120, 220) stromabwärts von dem Ventilsitz (18, 118, 218); und
einen Ventilteller (30, 130, 230), aufweisend eine Sitzfläche, wobei der Ventilteller (30, 130, 230) in der Austrittsdüse (20, 120, 220) entlang einer Länge der Effusionszelle (10) axial bewegbar ist, und zwar von einer geschlossenen Position, in welcher sich die Sitzflächen des Ventilsitzes (18, 118, 218) und des Ventiltellers (30, 130, 230) kontaktieren, zu einer offenen Position, in welcher die Sitzflächen des Ventilsitzes (18, 118, 218) und des Ventiltellers (30, 130, 230) voneinander abgehoben sind;
**dadurch gekennzeichnet, dass** zumindest die Bereiche der Sitzflächen des Ventilsitzes (18, 118, 218) und des Ventiltellers (30, 130, 230), die miteinander in Kontakt stehen, wenn sich der Ventilteller (30, 130, 230) in der geschlossenen Postition befindet, im Wesentlichen planar sind.

2. Effusionszelle (10) nach Anspruch 1, bei der die Öffnung (19, 119, 219) des Ventilsitzes (18, 118, 218) einen Durchmesser A_{D} aufweist, die Tiegelkammer (14) einen inneren Durchmesser C_{D} aufweist und das Verhältnis A_{D} zu C_{D} zumindest 0,01 zu 1 beträgt.

3. Effusionszelle (10) nach Anspruch 2, bei der das Verhältnis A_{D} zu C_{D} zumindest 0,2 zu 1 beträgt.

4. Effusionszelle (10) nach Anspruch 2, bei der das Verhältnis A_{D} zu C_{D} zwischen 0,5 zu 1 und 1 zu 1 beträgt.

5. Effusionszelle (10) nach Anspruch 1, bei der die Öffnung (19, 119, 219) des Ventilsitzes (18, 118, 218) einen Durchmesser A_{D} aufweist, die Tiegelkammer (14) einen inneren Durchmesser C_{D} aufweist, der Ventilteller (30, 130, 230) einen Einlassdurchmesser D_{ID} aufweist und das Verhältnis A_{D} zu C_{D} und/oder das Verhältnis D_{ID} zu C_{D} größer als 0,1 zu 1 ist.

6. Effusionszelle (10) nach Anspruch 5, bei der das Verhältnis A_{D} zu C_{D} größer als 0,2 zu 1 ist.

7. Effusionszelle (10) nach Anspruch 5, bei der das Verhältnis A_{D} zu C_{D} größer als 0,5 zu 1 ist.

8. Effusionszelle (10) nach Anspruch 5, bei der das Verhältnis D_{ID} von C_{D} größer als 0,2 zu 1 ist.

9. Effusionszelle (10) nach Anspruch 5, bei der das Verhältnis D_{ID} zu C_{D} größer als 0,5 zu 1 ist.

10. Effusionszelle (10) nach einem der vorhergehenden Ansprüche, bei der die im Wesentlichen planare Sitzfläche des Ventilsitzes (18, 218) in einer Ebene liegt, die im Wesentlichen senkrecht zu der axialen Länge der Effusionszelle (10) ist.

11. Effusionszelle (10) nach einem der vorhergehenden Ansprüche, bei der ein Bereich der Sitzfläche des Ventilsitzes (218) in die im Wesentlichen planare Sitzfläche eingelassen ist oder davon hervorsteht.

12. Effusionszelle (10) nach einem der vorhergehenden Ansprüche, bei der die im Wesentlichen planare Sitzfläche des Ventiltellers (30, 230) in einer Ebene liegt, die im Wesentlichen senkrecht zu der axialen Länge der Effusionszelle (10) ist,

13. Effusionszelle (10) nach einem der vorhergehenden Ansprüche, bei der ein Bereich der Sitzfläche des Ventiltellers (130) in die im Wesentlichen planare Sitzfläche eingelassen ist oder davon hervorsteht.

14. Effusionszelle (10) nach Anspruch 1, bei welcher der Ventilteller (30, 130, 230) einen Einlassdurchmesser D_{ID} aufweist, eine Dicke Der aufweist und das Verhältnis D_{ID} zu D_{T} größer als 2 zu 1 ist.

15. Effusionszelle (10) nach Anspruch 14, bei der das Verhältnis D_{ID} zu Der größer als 5 zu 1 ist.

16. Effusionszelle (10) nach Anspruch 14, bei der das Verhältnis D_{ID} zu D_{T} größer als 10 zu 1 ist.

17. Effusionszelle (10) nach einem der vorhergehenden Ansprüche, bei welcher der Ventilteller (30, 130) eine konusförmige Seite aufweist.

18. Effusionszelle (10) nach Anspruch 17, bei der die konusförmige Seite des Ventiltellers (30) nach innen in Richtung eines Auslassendes der Effusionszelle (10) geneigt ist.

19. Effusionszelle (10) nach einem der vorhergehenden Ansprüche, bei der die Austrittsdüse (20, 120, 220) einen Einlassdurchmesser N_{ID} aufweist, der Ventilteller (30, 130, 230) einen Einlassdurchmesser D_{ID} aufweist und das Verhältnis D_{ID} zu N_{ID} größer als 0,3 zu 1 ist.

20. Effusionszelle (10) nach Anspruch 19, bei der das Verhältnis D_{ID} zu N_{ID} größer als 0,5 zu 1 ist.

21. Effusionszelle (10) nach einem der vorhergehenden Ansprüche, bei der die Austrittsdüse (20, 120, 220) und der Ventilsitz (18, 118, 218) integral sind.

## Revendications

1. Cellule d'effusion (10) comprenant :
un creuset (12) ayant une chambre intérieure (14) et une extrémité ouverte (16) ;
un siège de soupape (18, 118, 218) adjacent à l'extrémité ouverte (16) du creuset (12) comprenant une ouverture (19, 119, 219) en communication d'écoulement avec l'extrémité ouverte (16) du creuset (12), et une surface de portée entourant l'ouverture (19, 119, 219) ;
une buse de sortie (20, 120, 220) en aval du siège de soupape (18, 118, 218) ; et
un disque de soupape (30, 130, 230) comprenant une surface de portée, dans laquelle le disque de soupape (30, 130, 230) est mobile axialement à l'intérieur de la buse de sortie (20, 120, 220) le long d'une longueur de la cellule d'effusion (10) depuis une position fermée dans laquelle les surfaces de portée du siège de soupape (18, 118, 218) et du disque de soupape (30, 130, 230) sont en contact l'une avec l'autre, jusqu'à une position ouverte dans laquelle les surfaces de portée du siège de soupape (18, 118, 218) et du disque de soupape (30, 130, 230) sont désengagées ;
**caractérisée en ce qu'**au moins les parties des surfaces de portée du siège de soupape (18, 118, 218) et du disque de soupape (30, 130, 230), qui sont en contact l'une avec l'autre lorsque le disque de soupape (30, 130, 230) est dans la position fermée, sont sensiblement planes.

2. Cellule d'effusion (10) selon la revendication 1, dans laquelle l'ouverture (19, 119, 219) du siège de soupape (18, 118, 218) a un diamètre A_{D}, la chambre de creuset (14) a un diamètre intérieur C_{D}, et le rapport de A_{D}:C_{D} est au moins de 0,01:1.

3. Cellule d'effusion (10) selon la revendication 2, dans laquelle le rapport de A_{D}:C_{D} est au moins de 0,2:1.

4. Cellule d'effusion (10) selon la revendication 2, dans laquelle le rapport de A_{D}:C_{D} est de 0,5:1 à 1:1.

5. Cellule d'effusion (10) selon la revendication 1, dans laquelle l'ouverture (19, 119, 219) du siège de soupape (18, 118, 218) a un diamètre A_{D}, la chambre de creuset (14) a un diamètre intérieur C_{D}, le disque de soupape (30, 130, 230) a un diamètre d'entrée D_{ID}, et le rapport de A_{D}:C_{D} et/ou le rapport de D_{ID}:C_{ID} est supérieur à 0,1:1.

6. Cellule d'effusion (10) selon la revendication 5, dans laquelle le rapport de A_{D}:C_{D} est supérieur à 0,2:1.

7. Cellule d'effusion (10) selon la revendication 5, dans laquelle le rapport de A_{D}:C_{D} est supérieur à 0,5:1.

8. Cellule d'effusion (10) selon la revendication 5, dans laquelle le rapport de D_{ID}:C_{D} est supérieur à 0,2:1.

9. Cellule d'effusion (10) selon la revendication 5, dans laquelle le rapport de D_{ID}:C_{D} est supérieur à 0,5:1.

10. Cellule d'effusion (10) selon l'une quelconque des revendications précédentes, dans laquelle la surface de portée sensiblement plane du siège de soupape (18, 218) est dans un plan sensiblement perpendiculaire à la longueur axiale de la cellule d'effusion (10).

11. Cellule d'effusion (10) selon l'une quelconque des revendications précédentes, dans laquelle une partie de la surface de portée du siège de soupape (218) est évidée ou surélevée par rapport à la surface de portée sensiblement plane.

12. Cellule d'effusion (10) selon l'une quelconque des revendications précédentes, dans laquelle la surface de portée sensiblement plane du disque de soupape (30, 230) est dans un plan sensiblement perpendiculaire à la longueur axiale de la cellule d'effusion (10).

13. Cellule d'effusion (10) selon l'une quelconque des revendications précédentes, dans laquelle une partie de la surface de portée du disque de soupape (130) est évidée ou surélevée par rapport à la surface de portée sensiblement plane.

14. Cellule d'effusion (10) selon la revendication 1, dans laquelle le disque de soupape (30, 130, 230) a un diamètre d'entrée D_{ID}, une épaisseur D_{T}, et le rapport de D_{ID}:D_{T} est supérieur à 2:1.

15. Cellule d'effusion (10) selon la revendication 14, dans laquelle le rapport de D_{ID}:D_{T} est supérieur à 5:1.

16. Cellule d'effusion (10) selon la revendication 14, dans laquelle le rapport de D_{ID}:D_{T} est supérieur à 10:1.

17. Cellule d'effusion (10) selon l'une quelconque des revendications précédentes, dans laquelle le disque de soupape (30, 130) a un côté biseauté.

18. Cellule d'effusion (10) selon la revendication 17, dans laquelle le côté biseauté du disque de soupape (30) est biseauté vers l'intérieur vers une extrémité de sortie de la cellule d'effusion (10).

19. Cellule d'effusion (10) selon l'une quelconque des revendications précédentes, dans laquelle la buse de sortie (20, 120, 220) a un diamètre d'entrée N_{ID}, le disque de soupape (30, 130, 230) a un diamètre d'entrée D_{ID}, et le rapport de D_{ID}:N_{ID} est supérieur à 0,3:1.

20. Cellule d'effusion (10) selon la revendication 19, dans laquelle le rapport de D_{ID}:N_{ID} est supérieur à 0,5:1.

21. Cellule d'effusion (10) selon l'une quelconque des revendications précédentes, dans laquelle la buse de sortie (20, 120, 220) et le siège de soupape (18, 118, 218) sont d'une seule pièce.
